# EUROPÄISCHE PATENTSCHRIFT

(11) **EP 3 471 214 B1**
(45) Veröffentlichungstag und Bekanntmachung des Hinweises auf die Patenterteilung: **25.11.2020**
(21) Anmeldenummer: 18199642.2
(22) Anmeldetag: 10.10.2018
(51) Int. Cl.: H01R 12/58, H05K 1/11

(54) **LEITERPLATTE UND VERFAHREN ZUM BESTÜCKEN EINER LEITERPLATTE MIT EINER ANZAHL VON EINPRESSKONTAKTSTIFTEN**
PRINTED CIRCUIT BOARD METHOD FOR LOADING A PRINTED CIRCUIT BOARD WITH A NUMBER OF PLUG-IN PINS
CARTE DE CIRCUITS IMPRIMÉS ET PROCÉDÉ DE MONTAGE D'UNE CARTE DE CIRCUITS IMPRIMÉS AVEC UN NOMBRE DE BROCHES À ENFONCER

(30) Priorität: 11.10.2017 DE 102017123673
(43) Veröffentlichungstag der Anmeldung: 17.04.2019
(73) Patentinhaber: Automotive Lighting Reutlingen GmbH, 72762 Reutlingen (DE)
(72) Erfinder: Neumann, Stefan, 71083 Herrenberg (DE)
(74) Vertreter: DREISS Patentanwälte PartG mbB

(56) Entgegenhaltungen:
- DE-A1-102012 223 940

## Beschreibung

Die Erfindung betrifft eine Leiterplatte nach dem Oberbegriff des Anspruchs 1. Nebengeordneten Ansprüche betreffen nach dem jeweiligen Oberbegriff eine Leiterplatte und ein Verfahren zum Bestücken einer Leiterplatte.

Einpresskontaktstifte sind allgemein bekannt, um, in Durchkontaktierung in einer Leiterplatte angeordnet, eine mechanische und elektrische Kontaktierung mit einem Steckverbinder bereitzustellen. Hierzu umfasst der Einpresskontaktstift einen distalen Einpressabschnitt zur Einpressung in eine dem Einpressabschnitt entsprechende Durchkontaktierung.

Damit Einpresskontaktstifte in verschiedenen Höhen von der Leiterplatte abstehen, müssen unterschiedlich lang gestaltete Einpresskontaktstifte vorgehalten werden. Hierdurch entstehen höhere Kosten.

Mithin ist es Aufgabe der Erfindung, eine Leiterplatte bereitzustellen, die die Fertigungskosten senkt.

Die der Erfindung zugrunde liegende Aufgabe wird durch eine Leiterplatte nach dem Anspruch 1 sowie durch ein Verfahren zum Bestücken einer Leiterplatte nach dem Anspruch 5 gelöst.

Vorteilhafte Weiterbildungen sind in den Unteransprüchen und in der nachfolgenden Beschreibung angegeben.

Beispielsweise ist ein proximaler Einpressabschnitt zur Einpressung in eine zweite Durchkontaktierung der Leiterplatte vorgesehen. Der proximale Einpressabschnitt weist eine Querausdehnung auf, welche größer ist als eine erste Querausdehnung des distalen Einpressabschnitts.

Vorteilhaft können so mit einem einzigen Einpresskontaktstift-Typ mehrere Höhen einer Abragung von Einpresskontaktstiften von einer Leiterplatte realisiert werden. Durch unterschiedliche Höhen der Abragung können werden bestimmte Funktionen realisiert, beispielsweise eine Erstkontaktierung der Masse beim Aufstecken eines Steckverbinders oder eine Überprüfung der Kontaktierung der Einpresskontaktstifte. Mithin wird unter Reduktion der Fertigungskosten eine Integration weiterer Steckfunktionen ermöglicht.

DE 10 2012 223940 A1 offenbart eine Anzahl von Kontaktiervorrichtungen einer ersten Art und Kontaktiervorrichtungen einer zweiten Art. Die Kontaktiervorrichtungen der ersten Art umfassen eine Spitzenschneide und eine Rumpfschneide. Die Kontaktiervorrichtungen der zweiten Art umfassen nur eine Spitzenschneide. Passende Durchgangsbohrungen sind in einer Leiterplatte ausgeführt.

In der nachfolgenden Zeichnung werden auch bei unterschiedlichen Ausführungsformen die Merkmale teilweise die gleichen Bezugszeichen verwendet, ohne dass hierauf nochmals explizit hingewiesen wird. In der Zeichnung zeigen:
- Figur 1: in einer Seitenansicht einen Einpresskontaktstift;
- Figur 2: in schematischer Schnittansicht eine Leiterplatte mit Einpresskontaktstiften;
- Figur 3: eine Vorrichtung zum Bestücken der Leiterplatte 2B in schematischer Form; und
- Figur 4: ein schematisches Ablaufdiagramm.

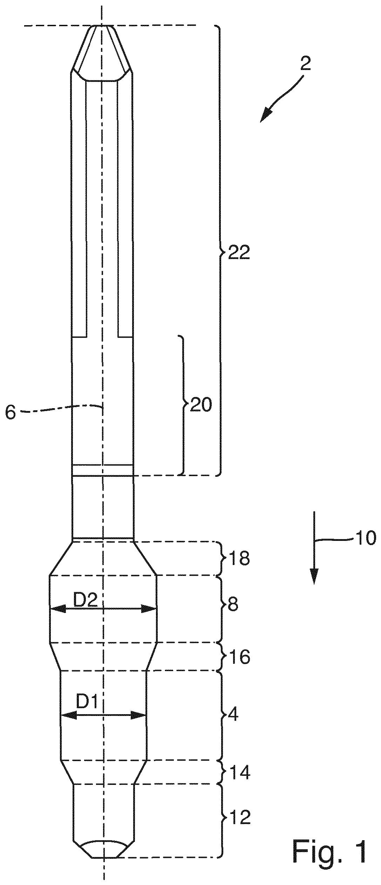

Figur 1 zeigt in einer Seitenansicht einen Einpresskontaktstift 2. Der Einpresskontaktstifte 2 umfasst einen distalen Einpressabschnitt 4 mit einer ersten Querausdehnung D1. Die Querausdehnung D1 bemisst sich in einer Lotebene der Längsachse 6 des Einpresskontaktstifts 2. In proximaler Richtung umfasst der Einpresskontaktstift 2 einen proximalen Einpressabschnitt 8. Der proximale Einpressabschnitt 8 weist eine zweite Querausdehnung D2 auf, welche größer ist als die erste Querausdehnung D1. Selbstverständlich sind Ausführungsformen denkbar, bei denen in einer Seitenansicht die Querausdehnungen D1 und D2 nicht wie vorgeschlagen ohne Weiteres ersichtlich sind, was aber lediglich bedeutet, dass die erste Querausdehnung D1 beispielsweise gegenüber der zweiten Querausdehnung D2 um die Längsachse verdreht ist. Bei den Querausdehnungen D1 und D2 handelt es sich somit eine jeweilige maximale Querausdehnung im Bereich der Einpressabschnitt 4 und 8.

Entgegen einer Einpressrichtung 10 schließt sich an einen distalen Einführabschnitt 12 ein Einlaufabschnitt 14 für den ersten distalen Einpressabschnitt 4 an. In Einpressrichtung 10 nimmt der Querschnitt des Einführabschnitts 14 ab. Zwischen dem distalen Einpressabschnitt 4 und dem proximalen Einpressabschnitt 8 ist ein Einlaufabschnitt 16 vorgesehen, der die beiden Einpressabschnitte 4 und 8 voneinander beabstandet. In proximaler Richtung schließt sich an den proximalen Einpressabschnitt 8 ein Auslaufabschnitt 18 an. Ein Angriffabschnitt 20 ist zur Halterung des Einpresskontaktstifts mittels einer Greifvorrichtung zu einer Einpressung vorgesehen. Entgegen der Einpressrichtung 10 ist ein Kontaktabschnitt 22 zur mechanischen und elektrischen Kontaktierung eines Gegensteckbereichs eines Gegensteckverbinders angeordnet. Der Einpresskontaktstift 2 ist beispielsweise aus einer verzinnten Kupferlegierung gefertigt.

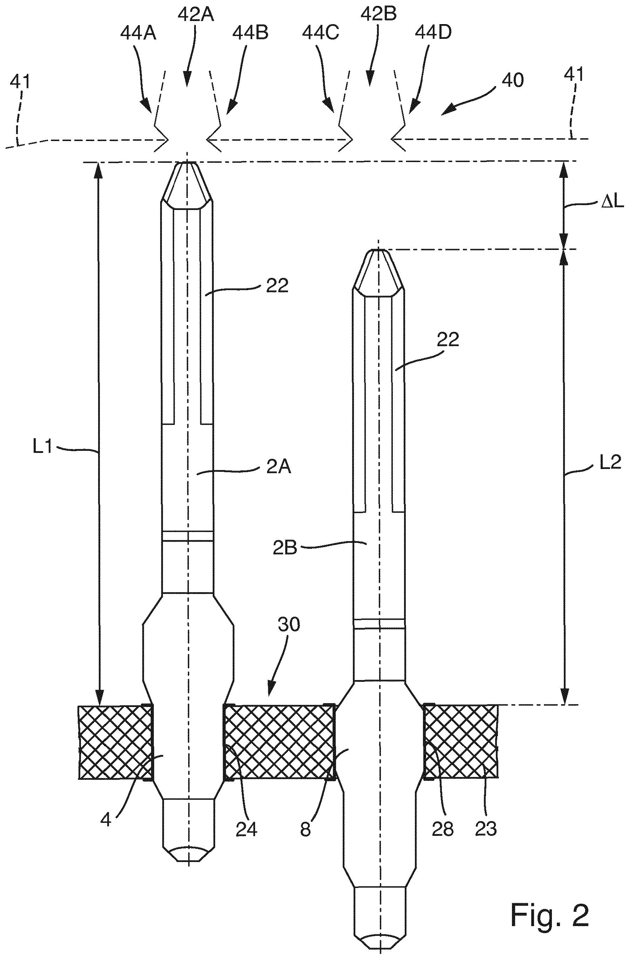

Figur 2 zeigt in schematischer Schnittansicht die Leiterplatte 23, in welcher der erste Einpresskontaktstift 2A mit seinem distalen Einpressabschnitt 4 in einer ersten Durchkontaktierung 24 eingepresst ist. Der zweite Einpresskontaktstift 2B ist mit seinem proximalen Einpressabschnitt 8 in einer zweiten Durchkontaktierung 28 eingepresst. Die Durchkontaktierungen 24 und 28 sind mit ihrem Innendurchmesser an den jeweiligen vorgesehenen Einpressbereich 4, 8 angepasst. Die Durchkontaktierungen 24 und 28 sind in einer jeweiligen Bohrung der Leiterplatte 23 angeordnet und umfassen beispielsweise verzinnte Kupferlegierung.

Das distale Ende des Kontaktbereichs 22 des ersten Einpresskontaktstifts 2A ragt um eine Länge L1 von einer Oberfläche 30 der Leiterplatte 23 ab. Das distale Ende des Kontaktbereichs 22 des zweiten Einpresskontaktstifts 2B ragt um eine gegenüber der Länge L1 verringerten Länge L2 von der Oberfläche 30 der Leiterplatte 23 ab. Damit ragt der erste Einpresskontaktstift 2A um einen Einpressunterschied ΔL gegenüber dem zweiten Einpresskontaktstift 2B vor. Der Einpressunterschied ΔL ist größer als die Dicke der Leiterplatte 23. Eine beispielhafte Leiterplattendicke von 1,6 mm vorausgesetzt, wird der Einpressunterschied ΔL von 1,8 mm gewählt, wobei der Einlaufabschnitt 16 die beiden Einpressabschnitte 4 und 8 um etwa 0,2 mm voneinander beabstandet.

Des Weiteren ist schematisch ein Gegensteckverbinder 40 gezeigt, welcher zu den Kontaktabschnitten 22 der Einpresskontaktstifte 2A und 2B korrespondierende Gegenkontaktabschnitte 42A und 42B aufweist. Die Gegenkontaktabschnitte 42A und 42B sind im Wesentlichen hohlzylindrisch ausgebildet und stellen zwei sich jeweils gegenüberliegende Kontaktelemente 44A und 44B sowie 44C und 44D zur Aufnahme und zur mechanischen und elektrischen Kontaktierung des jeweiligen Kontaktabschnitts 22 der Einpresskontaktstifte 2A und 2B dar. Die Kontaktelemente 44A-D stellen in einer Ebene 41 liegende Kontaktpunkte für die Einpresskontaktstifte 2A und 2B bereit.

In einer ersten Ausführungsform eilt der erste Einpresskontaktstift 2A als einziger Einpresskontaktstift gegenüber einer Anzahl zweiter Einpresskontaktstifte 2B vor. Der erste Einpresskontaktstift 2A ist zur Herstellung eines Massekontakts vorgesehen und entsprechend auf der Leiterplatte 23 zur Masseeinleitung verschaltet. Durch das Voreilen des Einpresskontaktstifts 2A wird Schäden an Steuergeräten durch Vorkontaktierung eines Nicht-Masseanschlusses vorgebeugt, da zuallererst die elektrische Kontaktierung des Masseanschlusses über den Einpresskontaktstift 2A erfolgt.

In einer zweiten Ausführungsform eilt der zweite Einpresskontaktstift 2B als einziger Einpresskontaktstift gegenüber einer Anzahl von ersten Einpresskontaktstiften 2A nach. Der zweite Einpresskontaktstift 2B ist dazu vorgesehen, um eine sichere Kontaktierung der Anzahl der ersten Einpresskontaktstifte 2A beispielsweise mithilfe einer Überprüfungseinrichtung auf der Leiterplatte 23 festzustellen. Fließt ein messbarer Strom über den nacheilenden zweiten Einpresskontaktstift 2B, so kann davon ausgegangen werden, dass eine Kontaktierung der Anzahl von ersten Einpresskontaktstiften 2A vorliegt.

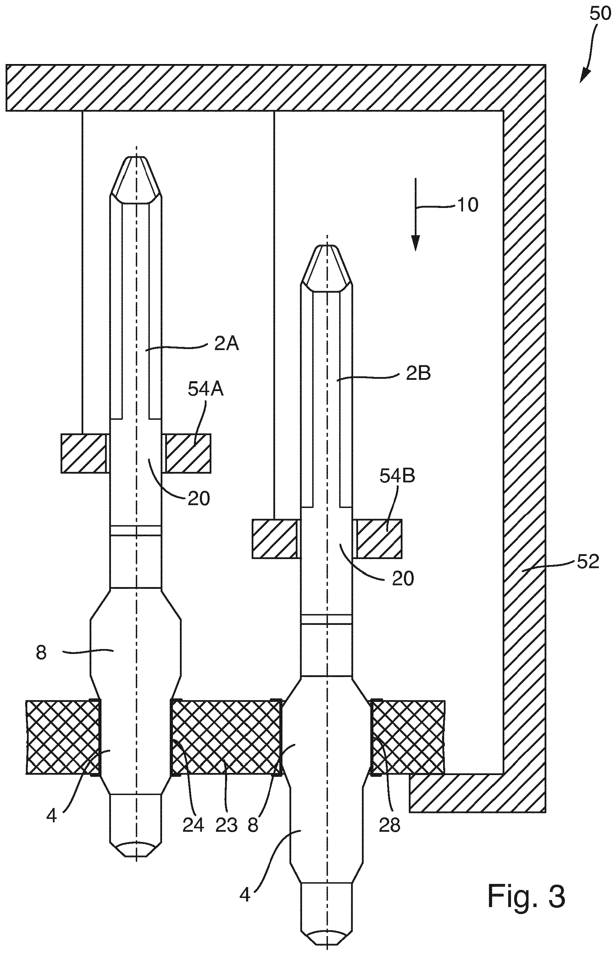

Figur 3 zeigt eine Vorrichtung 50 zum Bestücken der Leiterplatte 23 mit den Einpresskontaktstiften 2A und 2B in schematischer Form. An einem schematisch dargestellten Rahmen 52 liegt die Leiterplatte 23 an. An dem Rahmen 52 stützen sich Greifvorrichtungen 54A und 54B ab. Die Greifvorrichtungen 54A, 54B greifen an dem jeweiligen Angriffabschnitt 20 des jeweiligen Einpresskontaktstifts 2A und 2B an und drücken den jeweiligen Einpresskontaktstift 2A und 2B in die Einpressrichtung 10 und damit in die zugehörigen Durchkontaktierungen 24, 28. Es sind die jeweiligen Endlagen der Greifvorrichtungen 54A und 54B gezeigt. So stellt die Vorrichtung 50 unterschiedliche Einpresstiefen für die anzuordnenden Einpresskontaktstifte 2A und 2B bereit. Vorteilhaft entfällt durch eine derartige Vorrichtung 50 ein Werkzeugwechsel und es müssen nicht zusätzliche Verfahrwege vorgesehen werden.

In einem weiteren Beispiel kann die Vorrichtung 50 beispielsweise in zwei Bestück-Stationen aufgeteilt sein, wobei die erste Bestück-Station die erste Endlage der Greifvorrichtung 54A erreicht und die zweite Bestück-Station eine zweite Endlage der Greifvorrichtung 54B erreicht.

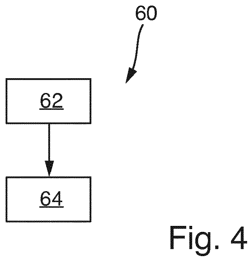

Figur 4 zeigt ein schematisches Ablaufdiagramm 60 zum Bestücken der Leiterplatte 23 mit einer Anzahl von Einpresskontaktstiften 2. In einem Schritt 62 wird ein distaler Einpressabschnitt 4 eines ersten der Einpresskontaktstifte 2 in die erste Durchkontaktierung 24 der Leiterplatte 23 eingepresst, wobei der distale Einpressabschnitt 4 eine erste Querausdehnung D2 aufweist. In einem Schritt 64 wird der proximale Einpressabschnitt 8 eines zweiten der Einpresskontaktstifte 2 in die zweite Durchkontaktierung 28 der Leiterplatte 23 eingepresst. Selbstverständlich können die Schritte 62 und 64 auch in umgekehrter Reihenfolge ausgeführt werden.

## Patentansprüche

1. Eine Leiterplatte (23) umfassend eine Anzahl von Einpresskontaktstiften (2A, 2B) zur Anordnung in einer jeweiligen Durchkontaktierung (24; 28) der Leiterplatte (23), wobei die Einpresskontaktstifte (2A, 2B) jeweils einen distalen Einpressabschnitt (4) und einen proximalen Einpressabschnitt (8) umfassen, wobei der distale Einpressabschnitt (4) zur Einpressung in die erste Durchkontaktierung (24) eine erste Querausdehnung (D1) aufweist, wobei der proximale Einpressabschnitt (8) zur Einpressung in eine zweite Durchkontaktierung (28) eine zweite Querausdehnung (D2) aufweist, welche größer ist als die erste Querausdehnung (D1),
- wobei ein erster der Einpresskontaktstifte (2A) mit seinem distalen Einpressabschnitt (4) in der ersten Durchkontaktierung (24) der Leiterplatte (23) gehalten wird, und
- wobei weitere der Einpresskontaktstifte (2B) mit ihrem proximalen Einpressabschnitt (8) in einer jeweiligen zweiten Durchkontaktierung (28) der Leiterplatte (23) gehalten werden.

2. Eine Leiterplatte (23) gemäß dem Anspruch 1,
- wobei ein erster der Einpresskontaktstifte (2B) mit seinem proximalen Einpressabschnitt (8) in der zweiten Durchkontaktierung (28) der Leiterplatte (23) gehalten wird, und
- wobei weitere der Einpresskontaktstifte (2A) mit ihrem distalen Einpressabschnitt (4) in einer jeweiligen ersten Durchkontaktierung (24) der Leiterplatte (23) gehalten werden.

3. Die Leiterplatte (23) nach dem Anspruch 1 oder 2 mit einem Steckverbinder (40), dessen Gegenkontaktabschnitte (42A, 42B) jeweils mit Kontaktabschnitten (22) der Einpresskontaktstifte (2A, 2B) mechanisch und elektrisch verbunden ist.

4. Die Leiterplatte (23) nach dem Anspruch 3, wobei die zu den Kontaktabschnitten (22) korrespondierenden Gegenkontaktabschnitte (42A, 42B) in Richtung der Einpresskontaktstifte (2A, 2B) in einer gemeinsamen gedachten Ebene (41) enden.

5. Ein Verfahren zum Bestücken einer Leiterplatte (23) mit einer Anzahl von Einpresskontaktstiften (2A, 2B), wobei die Einpresskontaktstifte (2A, 2B) jeweils einen distalen Einpressabschnitt (4) und einen proximalen Einpressabschnitt (8) umfassen, wobei der distale Einpressabschnitt (4) eine erste Querausdehnung (D1) aufweist, wobei der proximale Einpressabschnitt (8) eine zweite Querausdehnung (D2) aufweist, welche größer ist als die erste Querausdehnung (D1), das Verfahren umfassend:
- Einpressen (62) eines distalen Einpressabschnitts (4) eines ersten der Einpresskontaktstifte (2A) in eine erste Durchkontaktierung (24) der Leiterplatte (23),
- Einpressen (64) eines proximalen Einpressabschnitts (8) eines zweiten der Einpresskontaktstifte (2B) in eine zweite Durchkontaktierung (28) der Leiterplatte (23).

## Claims

1. A printed circuit board (23), comprising a number of press-in contact pins (2A, 2B) for arrangement in a respective throughplating (24; 28) of the printed circuit board (23), wherein the press-in contact pins (2A, 2B) each comprise a distal press-in portion (4) and a proximal press-in portion (8), wherein the distal press-in portion (4) has a first transverse extent (D1) for being pressed into the first throughplating (24), wherein the proximal press-in portion (8) has a second transverse extent (D2) for being pressed into the second throughplating (28), which is greater than the first transverse extent (D1),
- wherein a first one of the press-in contact pins (2P) is supported with its distal press-in portion (4) in the first throughplating (24) of the printed circuit board (23) and
- wherein further ones of the press-in contact pins (2B) are supported with their proximal press-in portions (8) in a respective second throughplating (28) of the printed circuit board (23).

2. A printed circuit board (23) as claimed in claim 1,
- wherein a first one of the press-in contact pins (2B) is supported with its proximal press-in portion (8) in the second throughplating (28) of the printed circuit board (23) and
- wherein further ones of the press-in contact pins (2A) are supported with their distal press-in portions (4) in a respective first throughplating (24) of the printed circuit board (23).

3. The printed circuit board (23) as claimed in claim 1 or 2 with a plug-in connector (40), the counter-contact portions (42A, 42B) of which each are mechanically and electrically connected to the contact portions (22) of the press-in contact pins (2A, 2B).

4. The printed circuit board (23) as claimed in claim 3, wherein the counter-contact portions (42A, 42B) corresponding to the contact portions (22) end in a common imaginary plane (41) in the direction of the press-in contact portions (2A, 2B).

5. A method for assembling a printed circuit board (23) with a number of press-in contact pins (2A, 2B), wherein the press-in contact pins (2A, 2B) each comprise a distal press-in portion (4) and a proximal press-in portion (8), wherein the distal press-in portion (4) has a first transverse extent (D1), wherein the proximal press-in portion (8) has a second transverse extent (D2) which is greater than the first transverse extent (D1), which method comprises:
- pressing (62) a distal press-in portion (4) of a first one of the press-in contact pins (2A) in a first throughplating (24) of the printed circuit board (23),
- pressing (64) a proximal press-in portion (8) of a second one of the press-in contact pins (2B) into a second throughplating (28) of the printed circuit board (23) .

## Revendications

1. Carte de circuits imprimés (23) comprenant un nombre de broches à enfoncer (2A, 2B) pour la disposition dans un via (24; 28) respectif, les broches à enfoncer (2A, 2B) comprenant chacune une zone d'enfoncement distale (4) et une zone d'enfoncement proximale (8), la zone d'enfoncement distale (4) présentant une première étendue transversale (D1) pour l'enfoncement dans le premier via (24), la zone d'enfoncement proximale (8) présentant une deuxième étendue transversale (D2) pour l'enfoncement dans un deuxième via (28) qui est supérieure à la première étendue transversale (D1),
- une première des broches à enfoncer (2A) étant maintenue par sa zone d'enfoncement distale (4) dans le premier via (24) de la carte de circuits imprimés (23), et
- d'autres des broches à enfoncer (2B) étant maintenues par leur zone d'enfoncement proximale (8) dans un deuxième via (28) respectif de la carte de circuits imprimés (23).

2. Carte de circuits imprimés (23) selon la revendication 1,
- une première des broches à enfoncer (2B) étant maintenue par sa zone d'enfoncement proximale (8) dans le deuxième via (28) de la carte de circuits imprimés (23), et
- d'autres des broches à enfoncer (2A) étant maintenues par leur zone d'enfoncement distale (4) dans un premier via (24) respectif de la carte de circuits imprimés (23).

3. Carte de circuits imprimés (23) selon la revendication 1 ou 2 avec un connecteur (40) dont chacune des zones de contre-contacts (42A, 42B) est reliée mécaniquement ou électriquement à des zones de contacts (22) des broches à enfoncer (2A, 2B).

4. Carte de circuits imprimés (23) selon la revendication 3, les zones de contre-contacts (42A, 42B) correspondant aux zones de contacts (22) se terminant en direction des broches à enfoncer (2A, 2B) dans un plan commun virtuel (41) .

5. Procédé pour équiper une carte de circuits imprimés (23) avec un nombre de broches à enfoncer (2A, 2B), les broches à enfoncer (2A, 2B) comprenant chacune une zone d'enfoncement distale (4) et une zone d'enfoncement proximale (8), la zone d'enfoncement distale (4) présentant une première étendue transversale (D1) pour l'enfoncement dans le premier via (24), la zone d'enfoncement proximale (8) présentant une deuxième étendue transversale (D2) pour l'enfoncement dans un deuxième via (28) qui est supérieure à la première étendue transversale (D1), le procédé comprenant:
- enfoncement (62) d'une zone d'enfoncement distale (4) d'une première (2A) des broches à enfoncer dans un premier via (24) de la carte de circuits imprimés (23),
- enfoncement (64) d'une zone d'enfoncement proximale (8) d'une deuxième (2B) des broches à enfoncer dans un deuxième via (28) de la carte de circuits imprimés (23).
